# EUROPEAN PATENT APPLICATION

(11) **EP 4 756 469 A1**
(43) Date of publication of application: **10.06.2026**
(21) Application number: 23947413.3
(22) Date of filing: 14.12.2023
(51) Int. Cl.: G01R 33/09, G01R 33/06

(54) **MULTI-AXIS MAGNETIC FIELD SENSOR AND MULTI-AXIS MAGNETIC FIELD SENSOR CHIP**

(30) Priority: 01.08.2023 CN 202310960429
(71) Applicant: MultiDimension Technology Co., Ltd., Jiangsu 215634 (CN)
(72) Inventor: LIU, Mingfeng, Jiangsu 215634 (CN); SHI, Ran, Jiangsu 215634 (CN); XUE, Songsheng, Jiangsu 215634 (CN)
(74) Representative: HGF
(86) International application number: PCT/CN2023/138648
(87) International publication number: WO 2025/025476

(57) **Abstract**

A multi-axis magnetic field sensor and a multi-axis magnetic field sensor chip. The multi-axis magnetic field sensor comprises: a first magnetizer (2z1), which is arranged on a first substrate (1a); a second magnetizer (2z3), which is arranged on a passivation layer (1c) or a second substrate (1b); a first air gap, which is formed on the basis of the first magnetizer (2z1) and the second magnetizer (2z3); a third magnetizer (2x1), which has a second air gap and is arranged on the substrate (1a or 1b) or the passivation layer (1c); a fourth magnetizer (2y1), which has a third air gap and is arranged on the substrate (1a or 1b) or the passivation layer (1c); and at least three magnetic induction units (at least one of 2x2a and 2x2c, at least one of 2y2a and 2y2b, and at least one of 2z2a, 2z2b, 2x2c, and 2z2d), which are respectively located in corresponding air gap regions, wherein the magnetic induction units in the passivation layer (1c) have the same magnetic induction sensitivity direction. Magnetic induction units in the same passivation layer of the multi-axis magnetic field sensor have the same magnetic induction sensitivity direction, such that the single-chip manufacturing of the multi-axis magnetic field sensor can be realized, and the manufactured multi-axis magnetic field sensor achieves better stability and higher precision.

## Description

### Technical Field

The present application relates to the technical field of magnetic induction, and more specifically, to a multi-axis magnetic field sensor and a multi-axis magnetic field sensor chip.

### Background of the Invention

A magnetic sensor is a device that converts changes in the magnetic properties of a sensitive element caused by external factors such as magnetic field, current, stress and strain, temperature, and light into electrical signals, thereby detecting corresponding physical quantities. It is widely used in modem industry and electronic products to measure physical parameters such as current, position, and direction by sensing changes in magnetic field strength.

Currently, most common triaxial magnetic field sensors use multi-chip packaging, for example, packaging a horizontal (XY axis) magnetic field sensor with a vertical (Z axis) magnetic field sensor. Existing triaxial magnetic field sensors have poor accuracy, are difficult to be integrated into a single chip, and have poor magnetic concentration effect in the vertical direction.

### Summary of the Invention

In view of this, the objective of the present application is to provide a multi-axis magnetic field sensor and a multi-axis magnetic field sensor chip to solve the technical problems of poor accuracy and difficulty in single-chip integrated manufacturing of existing triaxial magnetic field sensors.

In a first aspect, embodiments of the present application provide a multi-axis magnetic field sensor, which comprises: at least one first magnetizer in a third direction and arranged on a first substrate;
at least one second magnetizer in the third direction and arranged on a passivation layer or a second substrate; the difference between the number of the first magnetizer and the number of the second magnetizer is less than 2, and no overlapping region exists between the projections of the first magnetizer and the second magnetizer on the substrate or the overlapping region is less than half of the magnetic flux guiding region of the magnetizers; wherein the substrate is the first substrate or the second substrate, and the magnetic flux guiding region of the magnetizer is the magnetic flux guiding region of the first magnetizer or the magnetic flux guiding region of the second magnetizer;
a first air gap formed on the basis of the first magnetizer and the second magnetizer;
a third magnetizer in a second direction and arranged on the substrate or the passivation layer, the third magnetizer having a second air gap;
a fourth magnetizer in a first direction and arranged on the substrate or the passivation layer, the fourth magnetizer having a third air gap; wherein the first direction, the second direction, and the third direction are mutually perpendicular;
at least three magnetic induction units located in corresponding air gap regions, respectively; wherein the air gap regions comprise air gap regions of the first air gap, the second air gap, and the third air gap, and the sensors form, on the basis of the magnetic induction units, magnetic signal output circuits for measuring different magnetic induction intensity directions, respectively; wherein the passivation layer is a passivation protective layer around the magnetic induction units, and the magnetic induction units within the same passivation layer have the same magnetic induction sensitivity direction.

In the above implementation process, the multi-axis magnetic field sensor comprises: a first magnetizer in a third direction, a second magnetizer in the third direction, a first air gap formed on the basis of the first magnetizer and the second magnetizer, a third magnetizer having a second air gap, a fourth magnetizer having a third air gap, and at least three magnetic induction units, and a magnetic signal output circuit for measuring different magnetic induction intensity directions is formed on the basis of the magnetic induction units arranged in the corresponding air gap regions. Magnetic induction units in the same passivation layer have the same magnetic induction sensitivity direction, such that the single-chip manufacturing of the multi-axis magnetic field sensor can be realized, and the manufactured multi-axis magnetic field sensor achieves better stability and higher precision. The adoption of the multi-axis magnetic field sensor provided by the present application can solve the "technical problems of poor accuracy and difficulty in single-chip integrated manufacturing of existing triaxial magnetic field sensors."

In addition, the present application adopts a double-layer spaced soft magnetic array vertical detection structure (i.e., a vertical magnetic field measurement region formed by the first magnetizer and the second magnetizer), which solves the problems of uneven magnetic field distribution, severe sensitivity loss, low accuracy, and high noise in the measurement direction of a single-layer array of strip-shaped soft magnetic sheets, and enhances the magnetic concentration effect and magnetic field uniformity in the vertical direction, thereby achieving higher magnetic field conversion efficiency, improving sensitivity, improving overall accuracy, sensitivity, and stability of the triaxial sensor, and reducing noise.

Optionally, in the embodiments of the present application, the third magnetizer comprises: a third magnetic field input region in the second direction and located at two ends of the third magnetizer and a third magnetic field conversion region located between two ends of the third magnetizer; the third magnetic field conversion region comprises a third magnetic field conversion magnetic circuit in the first direction; wherein the third magnetic field conversion magnetic circuit has the second air gap.

In the above implementation process, a magnetic field to be measured in the second direction input by the third magnetic field input region is converted on the basis of the third magnetic field conversion region, a magnetic field component to be measured in the first direction is formed in the third magnetic field conversion magnetic circuit in the first direction, and then, a first magnetic signal output circuit for measuring the magnetic induction intensity in the first direction is formed through the second magnetic induction unit located in the second air gap region.

Optionally, in the embodiments of the present application, the second air gap comprises a first conversion air gap and a second conversion air gap; the third magnetic field conversion magnetic circuit comprises a first conversion magnetic circuit and a second conversion magnetic circuit that are adjacent; the first conversion magnetic circuit has the first conversion air gap, and the second conversion magnetic circuit has the second conversion air gap; and the sensor forms a second magnetic signal output circuit for detecting the magnetic induction intensity in the second direction on the basis of a first conversion magnetic induction unit and a second conversion magnetic induction unit; wherein the first conversion magnetic induction unit and the second conversion magnetic induction unit are located in the air gap regions of the first conversion air gap and the second conversion air gap, respectively.

In the above implementation process, since the first conversion magnetic circuit and the second conversion magnetic circuit are adjacent conversion magnetic circuits in the first direction, after a magnetic field to be measured enters from the "third magnetic field input region in the second direction," magnetic field components with opposite directions will be formed at the first conversion air gap and the second conversion air gap, and the resistance values of the first conversion magnetic induction unit and the second conversion magnetic induction unit will change in opposite directions, thereby enabling more sensitive reflection of changes to the magnetic field to be measured in the second direction, and improving the detection sensitivity of the multi-axis magnetic field sensor for the magnetic induction intensity in the second direction.

Optionally, in the embodiments of the present application, the fourth magnetizer comprises: a fourth magnetic field input region in the first direction and located at two ends of the fourth magnetizer, and a fourth magnetic field conversion region located between two ends of the fourth magnetizer; the fourth magnetic field conversion region comprises a fourth magnetic field conversion magnetic circuit in the second direction; wherein the fourth magnetic field conversion magnetic circuit has the third air gap.

In the above implementation process, a magnetic field to be measured in the first direction input by the fourth magnetic field input region is converted on the basis of the fourth magnetic field conversion region, a magnetic field component to be measured in the second direction is formed in the fourth magnetic field conversion magnetic circuit in the second direction, and then, a second magnetic signal output circuit for measuring the magnetic induction intensity in the second direction is formed through the third magnetic induction unit located in the third air gap region.

Optionally, in the embodiments of the present application, the third air gap comprises a third conversion air gap and a fourth conversion air gap; the fourth magnetic field conversion magnetic circuit comprises a third conversion magnetic circuit and a fourth conversion magnetic circuit that are adjacent; the third conversion magnetic circuit has the third conversion air gap, and the fourth conversion magnetic circuit has the fourth conversion air gap; and the sensor forms a first magnetic signal output circuit for detecting the magnetic induction intensity in the first direction on the basis of a third conversion magnetic induction unit and a fourth conversion magnetic induction unit; wherein the third conversion magnetic induction unit and the fourth conversion magnetic induction unit are located in the air gap regions of the third conversion air gap and the fourth conversion air gap, respectively.

In the above implementation process, since the third conversion magnetic circuit and the fourth conversion magnetic circuit are adjacent conversion magnetic circuits in the second direction, after a magnetic field to be measured enters from the "third magnetic field input region in the first direction," magnetic field components with opposite directions will be formed at the third conversion air gap and the fourth conversion air gap, and the resistance values of the third conversion magnetic induction unit and the fourth conversion magnetic induction unit will change in opposite directions, thereby enabling more sensitive reflection of changes to the magnetic field to be measured in the first direction, and improving the detection sensitivity of the multi-axis magnetic field sensor for the magnetic induction intensity in the first direction.

Optionally, in the embodiments of the present application, the sensor further comprises: a first magnetic shielding magnetic induction unit; the projection of the first magnetic shielding magnetic induction unit on the substrate is located within the magnetic flux guiding region of the third magnetizer; and the sensor forms a second magnetic signal output circuit for detecting the magnetic induction intensity in the second direction on the basis of a first magnetic induction unit located in the second air gap region and the first magnetic shielding magnetic induction unit.

In the above implementation process, since the projection of the first magnetic shielding induction unit on the substrate is located in the magnetic flux guiding region of the third magnetizer, what the first magnetic shielding induction unit detects is a magnetic field signal weakened by the third magnetizer, and therefore, the resistance of the first magnetic shielding induction unit remains almost unchanged compared with the resistance change of the first magnetic induction unit. The second magnetic signal output circuit for detecting the magnetic induction intensity in the second direction formed by the first magnetic induction unit and the first magnetic shielding magnetic induction unit has low sensitivity and can have a larger magnetic field strength detection range, thereby realizing a wide-range, low-sensitivity measurement of the magnetic induction intensity in the second direction.

Optionally, in the embodiments of the present application, the sensor further comprises: a second magnetic shielding magnetic induction unit; the projection of the second magnetic shielding magnetic induction unit on the substrate is located within the magnetic flux guiding region of the fourth magnetizer; and the sensor forms a first magnetic signal output circuit for detecting the magnetic induction intensity in the first direction on the basis of a second magnetic induction unit located in the third air gap region and the second magnetic shielding magnetic induction unit.

In the above implementation process, since the projection of the second magnetic shielding induction unit on the substrate is located in the magnetic flux guiding region of the fourth magnetizer, what the second magnetic shielding induction unit detects is a magnetic field signal weakened by the fourth magnetizer, and therefore, the resistance of the second magnetic shielding induction unit remains almost unchanged compared with the resistance change of the second magnetic induction unit. The first magnetic signal output circuit for detecting the magnetic induction intensity in the first direction formed by the second magnetic induction unit and the second magnetic shielding magnetic induction unit has low sensitivity and can have a larger magnetic field strength detection range, thereby realizing a wide-range, low-sensitivity measurement of the magnetic induction intensity in the first direction.

Optionally, in the embodiments of the present application, the sensor further comprises: an external magnetic field magnetic induction unit; the distances from the external magnetic field magnetic induction unit to the first magnetizer, the second magnetizer, the third magnetizer, and the fourth magnetizer are all greater than a preset distance; and the sensor forms. on the basis of the magnetic induction units and the external magnetic field magnetic induction unit, magnetic signal output circuits for measuring different magnetic induction intensity directions, respectively.

In the above implementation process, since the distance from the external magnetic field magnetic induction unit to the first magnetizer, to the second magnetizer, to the third magnetizer, and to the fourth magnetizer is relatively far (greater than the preset distance), the external magnetic field magnetic induction unit will be directly affected by an external magnetic field (compared with the magnetic field inside the first magnetizer, the second magnetizer, the third magnetizer, and the fourth magnetizer, the external magnetic field refers to an external magnetic field to be measured). Therefore, the magnetic signal output circuit for measuring different magnetic induction intensity directions formed by the external magnetic field magnetic induction unit and a corresponding magnetic induction unit has low sensitivity and can have a larger magnetic field strength detection range, thereby realizing a wide-range, low-sensitivity measurement of the magnetic induction intensity in various directions.

Optionally, in the embodiments of the present application, grooves in the substrate are prepared by a backside deep reactive ion etching (DRIE) process, and after depositing a soft magnetic metal material in the grooves, a chemical mechanical polishing (CMP) process is used for polishing.

In the above implementation process, grooves are formed by using the backside deep reactive ion etching (DRIE) process, which can enhance the magnetic concentration effect and improve the sensitivity, and solve the technical problems of low magnetic field conversion efficiency, sensitivity loss, and high noise in the measurement direction of the magnetic flux concentration structures in the prior art.

Optionally, in the embodiments of the present application, the sensor further comprises: a resistor (preferably a fixed resistor); and the sensor forms, on the basis of the magnetic induction units and the resistor, magnetic signal output circuits for measuring different magnetic induction intensity directions, respectively.

In the above implementation process, a magnetic signal output circuit for measuring the magnetic induction intensity in various directions can be formed by using a resistor and corresponding magnetic induction units, which results in a simpler structure and can reduce the actual process packaging difficulty. In addition, the magnetic signal output circuit formed by the resistor and corresponding magnetic induction units has low sensitivity and can have a larger magnetic field strength detection range, thereby realizing a wide-range, low-sensitivity measurement of the magnetic induction intensity in various directions.

Optionally, in the embodiments of the present application, the sensor further comprises: an open-loop signal conditioning circuit; the open-loop signal conditioning circuit and the magnetic signal output circuit are electrically connected; the sensor performs conditioning and amplification, temperature compensation, and/or linearity correction on an electrical signal output by the magnetic signal output circuit on the basis of the open-loop signal conditioning circuit to obtain a first conditioned signal; and outputs the first conditioned signal; or, the sensor further comprises: a closed-loop signal conditioning circuit and a magnetic field feedback coil; the sensor forms a closed-loop magnetic field feedback structure on the basis of the closed-loop signal conditioning circuit, the magnetic field feedback coil, and the magnetic induction unit; the sensor performs conditioning and amplification, temperature compensation, and/or linearity correction on an electrical signal output by the magnetic signal output circuit on the basis of the closed-loop magnetic field feedback structure, and generates a feedback magnetic field to achieve dynamic magnetic field balance, thereby obtaining a second conditioned signal; and outputs the second conditioned signal; wherein the second conditioned signal represents a feedback current of the magnetic field feedback coil that achieves the state of dynamic magnetic field balance.

In the above implementation process, after a signal conditioning circuit (the open-loop signal conditioning circuit/closed-loop signal conditioning circuit and magnetic field feedback coil) performs conditioning and amplification, temperature compensation, and/or linearity correction on the electrical signal output by the magnetic signal output circuit, a conditioned standard signal (the first conditioned signal/second conditioned signal) can be obtained, so as to ensure that the conditioned standard signal can be more accurately identified by a corresponding magnetic detection system, thereby improving the accuracy of the magnetic field detection results obtained on the basis of the multi-axis magnetic field sensor.

In a second aspect, embodiments of the present application provide a multi-axis magnetic field sensor chip, and the multi-axis magnetic field sensor chip is formed by packaging the multi-axis magnetic field sensor according to any one of the above first aspect by means of wafer-level packaging (WLP) and through silicon via (TSV) processes.

By adopting the multi-axis magnetic field sensor provided in the present application, a magnetic signal output circuit for measuring different magnetic induction intensity directions is formed through magnetic induction units arranged in the corresponding air gap regions. Since the magnetic induction units in the same passivation layer have the same magnetic induction sensitivity direction, the multi-axis magnetic field sensor provided in the present application can be fabricated on a single chip, and moreover, the fabricated multi-axis magnetic field sensor has better stability and higher accuracy, which solves the technical problems that "existing triaxial magnetic field sensors have poor accuracy and are difficult to achieve single-chip integrated manufacturing."

### Brief Description of the Accompanying Drawings

In order to more clearly illustrate the technical solutions in the embodiments of the present application, the drawings required in the embodiments of the present application will be briefly introduced below. It should be understood that the accompanying drawings below are merely some embodiments of the present application, and therefore should not be construed as limitations on the scope. Those skilled in the art may derive additional relevant drawings on the basis of these drawings without any creative work.
FIG. 1 is a structural schematic diagram of a first type of multi-axis magnetic field sensor provided in an embodiment of the present application;
FIG. 2 is a structural schematic diagram of a second type of multi-axis magnetic field sensor provided in an embodiment of the present application;
FIG. 3 is a simulation diagram of a first type of magnetic flux path provided in an embodiment of the present application;
FIG. 4 is a simulation diagram of a second type of magnetic flux path provided in an embodiment of the present application;
FIG. 5 is a structural schematic diagram of a third type of multi-axis magnetic field sensor provided in an embodiment of the present application;
FIG. 6 is a structural schematic diagram of a fourth type of multi-axis magnetic field sensor provided in an embodiment of the present application;
FIG. 7 is a structural schematic diagram of a fifth type of multi-axis magnetic field sensor provided in an embodiment of the present application;
FIG. 8 is a simulation diagram of a third type of magnetic flux path provided in an embodiment of the present application.

### Detailed Description of Specific Embodiments

The embodiments of the technical solutions of the present application will be described in detail below with reference to the accompanying drawings. The following embodiments are only used to illustrate the technical solutions of the present application more clearly, are therefore only examples, and should not be used to limit the scope of protection of the present application.

Unless otherwise defined, all technical and scientific terms used herein have the same meaning as commonly understood by one of ordinary skill in the art to which the present application belongs; the terminology used herein is for the purpose of describing particular embodiments only and is not intended to limit the present application.

In the description of the embodiments of the present application, the technical terms "first," "second," etc. are used only to distinguish different objects and should not be construed as indicating or implying relative importance or implicitly indicating the number, specific order, or primary and secondary relationship of the indicated technical features. In the description of the embodiments of the present application, "multiple" means two or more, unless otherwise explicitly specified.

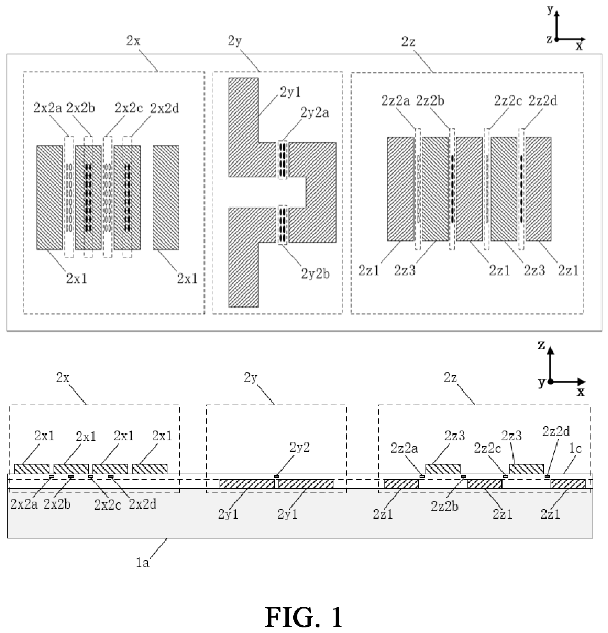

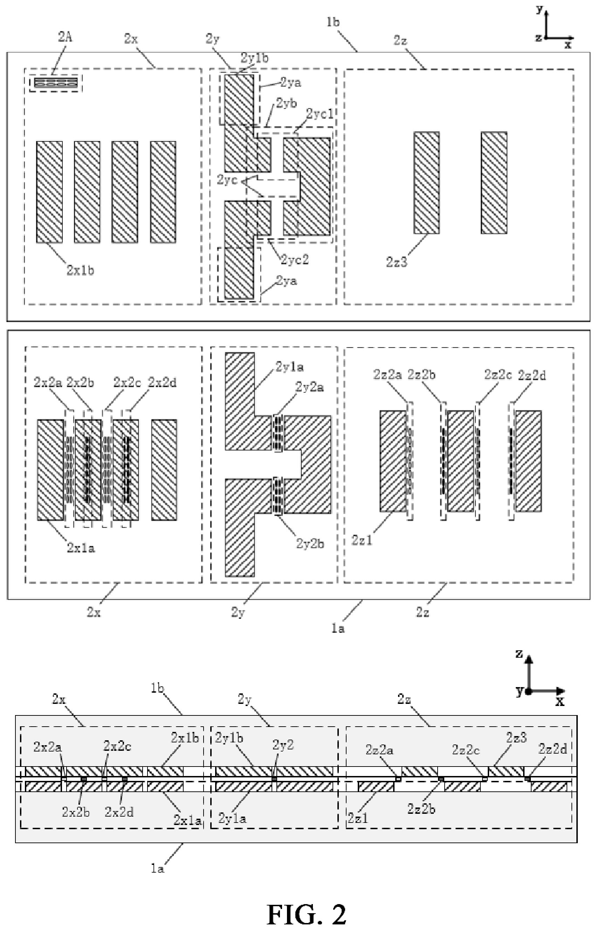

FIG. 1 is a structural schematic diagram of a first type of multi-axis magnetic field sensor provided in an embodiment of the present application. Specifically, the upper part of FIG. 1 shows a structural schematic diagram of the projection of the multi-axis magnetic field sensor on the plane (XY plane) where the first substrate 1a is located, and the lower part of FIG. 1 shows a structural schematic diagram of the projection of the multi-axis magnetic field sensor on the XZ plane (with the plane where the first substrate is located as the XY plane). FIG. 2 is a structural schematic diagram of a second type of multi-axis magnetic field sensor provided in the embodiments of the present application. Specifically, the upper part of FIG. 2 shows a structural schematic diagram of the projection of "the component between the passivation layer 1c and the second substrate 1b" in the multi-axis magnetic field sensor on the plane (XY plane) where the second substrate 1b is located, the middle part of FIG. 2 shows a structural schematic diagram of the projection of "the passivation layer 1c and the component between the passivation layer 1c and the first substrate 1a" in the multi-axis magnetic field sensor on the plane (XY plane) where the first substrate 1a is located, and the lower part of FIG. 2 shows a structural schematic diagram of the projection of the multi-axis magnetic field sensor on the XZ plane (with the plane where the first substrate 1a or the second substrate 1b is located as the XY plane). This multi-axis magnetic field sensor comprises:
at least one first magnetizer 2z1 in a third direction and arranged on the first substrate 1a;
at least one second magnetizer 2z3 in the third direction and arranged on the passivation layer 1c or the second substrate 1b; the difference between the number of the first magnetizer 2z1 and the number of the second magnetizer 2z3 is less than 2, and no overlapping region exists between the projections of the first magnetizer 2z1 and the second magnetizer 2z3 on the substrate or the overlapping region is less than half of the magnetic flux guiding region of the magnetizers; wherein the substrate is the first substrate 1a or the second substrate 1b, and the magnetic flux guiding region of the magnetizer is the magnetic flux guiding region of the first magnetizer 2z1 or the magnetic flux guiding region of the second magnetizer 2z3;
a first air gap formed on the basis of the first magnetizer 2z1 and the second magnetizer 2z3;
a third magnetizer 2x1 (which may comprise 2xla and 2x1b) in a second direction and arranged on the substrate (the first substrate 1a or the second substrate 1b) or the passivation layer 1c, the third magnetizer 2x1 having a second air gap;
a fourth magnetizer 2y1 (which may comprise 2yla and 2ylb) in a first direction and arranged on the substrate (the first substrate 1a or the second substrate 1b) or the passivation layer 1c, the fourth magnetizer 2y1 having a third air gap; wherein the first direction, the second direction, and the third direction are mutually perpendicular;
at least three magnetic induction units (at least one of 2x2a and 2x2c, at least one of 2y2a and 2y2b, and at least one of 2z2a, 2z2b, 2x2c, and 2z2d) located in corresponding air gap regions, respectively; wherein the air gap regions comprise air gap regions of the first air gap, the second air gap, and the third air gap, and the sensors form, on the basis of the magnetic induction units, magnetic signal output circuits for measuring different magnetic induction intensity directions, respectively; wherein the passivation layer 1c is a passivation protective layer around the magnetic induction units, and the magnetic induction units within the same passivation layer have the same magnetic induction sensitivity direction. The "magnetic induction sensitivity direction of the magnetic induction unit" located in the air gap region of the first air gap is consistent with the main magnetic field direction of the air gap region of the first air gap. The "magnetic induction sensitivity direction of the magnetic induction unit" located in the air gap region of the second air gap is consistent with the main magnetic field direction of the air gap region of the second air gap. The "magnetic induction sensitivity direction of the magnetic induction unit" located in the air gap region of the third air gap is consistent with the main magnetic field direction of the air gap region of the third air gap.

Here, the direction of a magnetizer (the first magnetizer, the second magnetizer, the third magnetizer, and the fourth magnetizer) is consistent with the direction of the magnetic induction intensity measured by the "magnetic signal output circuit realized on the basis of the magnetizer." The aforementioned substrate (the first substrate 1a or the second substrate 1b) refers to a wafer substrate. The first magnetizer 2z1, the second magnetizer 2z3, the third magnetizer 2x1, and the fourth magnetizer 2y1 can be magnetic flux guiding regions formed on a substrate by soft magnetic metal materials, such as silicon steel sheets, low carbon steel, or iron-silicon alloys. The first air gap, the second air gap, and the third air gap refer to gaps between the soft magnetic metal materials; and the first air gap, the second air gap, and the third air gap can be gaps formed by the air or other non-magnetic materials. The number of the first air gaps can be one or more, and the number of the second air gaps can also be one or more, which are not specifically limited in the present application. Specifically, if the number of the first magnetizers 2z1 is 1 and the number of the second magnetizers 2z3 is 1, one first air gap can be formed on the basis of the first magnetizer 2z1 and the second magnetizer 2z3; if the number of the first magnetizers 2z1 is 1 and the number of the second magnetizers 2z3 is 2, or the number of the first magnetizers 2z1 is 2 and the number of the second magnetizers 2z3 is 1, then two first air gaps can be formed on the basis of the first magnetizers 2z1 and the second magnetizers 2z3. The magnetic induction unit can be a magnetoresistive (MR) thin film, and specifically, it can be a giant magnetoresistor (GMR), tunnel magnetoresistor (TMR), or anisotropic magnetoresistor (AMR). The first magnetizer 2z1 can be arranged in a groove of the first substrate 1a or on the surface of the first substrate 1a; the second magnetizer 2z3 can be arranged on the surface of the passivation layer or on the surface of the second substrate 1b or in a groove of the second substrate 1b; the third magnetizer 2x1 can be arranged on the surface or in a groove of the first substrate 1a, or on the surface or in a groove of the second substrate 1b, or on the surface of the passivation layer; and the fourth magnetizer 2y1 can be arranged on the surface or in a groove of the first substrate 1a, or on the surface or in a groove of the second substrate 1b, or on the surface of the passivation layer.

Here, the first magnetic signal output circuit for detecting the magnetic induction intensity in the first direction can be formed on the basis of the second magnetic induction unit (2y2a or 2y2b) and a resistor; the first magnetic signal output circuit can also be formed on the basis of the second magnetic induction unit (2y2a or 2y2b) and the external magnetic field magnetic induction unit 2A; or the first magnetic signal output circuit can also be formed on the basis of the second magnetic induction units 2y2a and 2y2b. The second magnetic signal output circuit for detecting the magnetic induction intensity in the second direction can be formed on the basis of the first magnetic induction unit (2x2a or 2x2c) and a resistor; the second magnetic signal output circuit can also be formed on the basis of the first magnetic induction unit (2x2a or 2x2c) and the external magnetic field magnetic induction unit 2A, and the first magnetic signal output circuit can also be formed on the basis of the first magnetic induction units 2x2a and 2x2c. The third magnetic signal output circuit for detecting the magnetic induction intensity in the third direction can be formed on the basis of the third magnetic induction unit (any one of 2z2a, 2z2b, 2x2c, or 2z2d) and the resistor, and the third direction refers to a direction perpendicular to the plane where the substrate (the first substrate 1a or the second substrate 1b) is located; the third magnetic signal output circuit can also be formed on the basis of the third magnetic induction unit (any one of 2z2a, 2z2b, 2x2c, or 2z2d) and the external magnetic field magnetic induction unit 2A, and the third magnetic signal output circuit can also be formed on the basis of the third magnetic induction units "2z2a and 2z2b," "2z2a and 2z2d," "2z2b and 2z2c," or "2z2c and 2z2d." The first magnetic signal output circuit, the second magnetic signal output circuit, and the third magnetic signal output circuit can be a differential half-bridge or differential full-bridge output circuit.

Taking the following as an example: as shown in FIG. 1, the plane where the first base 1a is located is the X-Y plane, the first direction is the Y-axis direction, the second direction is the X-axis direction, and the third direction is the Z-axis, then the left side is the magnetic field measurement region 2x in the X-axis direction, the middle is the magnetic field measurement region 2y in the Y-axis direction, and the right side is the magnetic field measurement region 2z in the Z-axis direction. The magnetic field measurement region 2z comprises a first magnetizer 2z1 and a second magnetizer 2z3 made of a soft magnetic metal material having high permeability. As shown in FIG. 1, in this embodiment, the multi-axis magnetic field sensor comprises three strip-shaped soft magnetic metal materials (the first magnetizers 2z1) formed on the first substrate 1a by deposition and semiconductor micromachining for detecting the magnetic induction intensity in the Z-axis direction, and the multiple first magnetizers 2z1 are spaced apart in the X-axis direction. After polishing the surface of the first magnetizer 2z1 using the chemical mechanical polishing (CMP) process and depositing a passivation layer, a magnetoresistive (MR) thin film is deposited on the surface of the passivation layer, and the third magnetic induction unit (2z2a, 2z2b, 2x2c, and 2z2d) is formed by means of semiconductor patterning micromachining. After depositing a passivation layer above the third magnetic induction unit (2z2a, 2z2b, 2x2c, and 2z2d) again to protect the magnetoresistive thin film, two strip-shaped soft magnetic metal materials (the second magnetizers 2z3) for detecting the magnetic induction intensity in the Z-axis direction are formed above the passivation layer by means of deposition and semiconductor micromachining, and the multiple second magnetizers 2z3 are spaced apart in the X-axis direction. The magnetoresistive (MR) thin film adopted by the third magnetic induction unit can be a giant magnetoresistor (GMR). FIG. 1 shows a case where no overlapping region exists between the projections of the first magnetizer 2z1 and the second magnetizer 2z3 on the first substrate. The vertical projections of the third magnetic induction units 2z2a, 2z2b, 2z2c, and 2z2d in the Z-axis direction (i.e., the projections of the third magnetic induction units 2z2a, 2z2b, 2z2c, and 2z2d on the first substrate 1a) are located in a region in which soft magnetic metal materials of the first magnetizer 2z1 and the second magnetizer 2z3 are spaced apart.

Specifically, the description takes the direction of the external magnetic field being the positive Z-axis direction and the magnetic induction sensitivity directions of the third magnetic induction units 2z2a, 2z2b, 2z2c, and 2z2d all being the positive X-axis direction as an example. At this point, the X-axis magnetic field component after conversion has the positive X-axis direction at the positions of the third magnetic induction units 2z2a and 2z2c, and the negative X-axis direction at the positions of the third magnetic induction units 2z2b and 2z2d. Since the magnetic induction sensitivity directions of the third magnetic induction units 2z2a, 2z2b, 2z2c, and 2z2d are all in the positive X-axis direction, the resistance values of the third magnetic induction units 2z2a and 2z2c decrease, while the resistance values of the third magnetic induction units 2z2b and 2z2d increase. Therefore, a push-pull full-bridge structure or a differential full-bridge structure formed on the basis of additional resistors can be used to sense a magnetic field to be measured in the Z-axis direction and generate a differential voltage signal. In addition, an open-loop signal conditioning circuit can also be used to perform conditioning and amplification, temperature compensation, and linearity correction on the generated differential voltage signal to form an output signal (the first conditioned signal) of the third magnetic signal output circuit used to detect the third direction (i.e., the Z-axis direction).

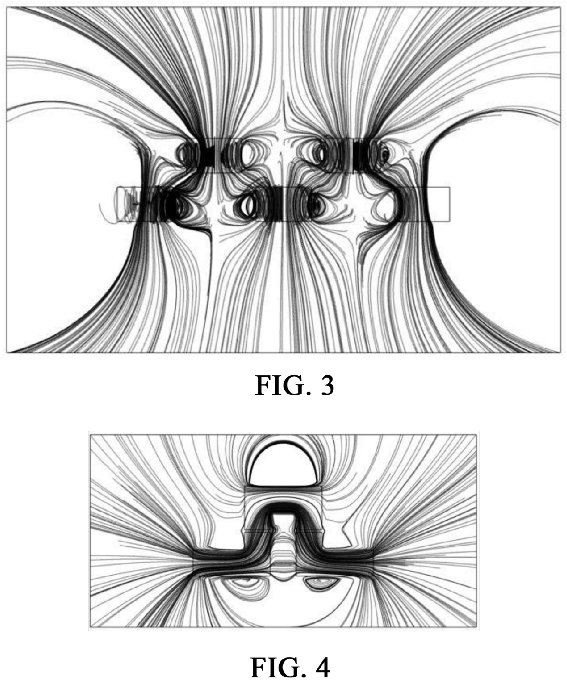

FIG. 3 is a simulation diagram of a first type of magnetic flux path provided in an embodiment of the present application. Specifically, FIG. 3 is a simulation diagram of the magnetic flux path after a magnetic field to be measured in the positive Z-axis direction is applied to the magnetic field measurement region 2z in the Z-axis direction in the embodiment provided in FIG. 1. It can be seen that the magnetic field to be measured is concentrated and amplified by the soft magnetic metal material to form a magnetic circuit. Since the soft magnetic metal material is distributed in a spaced-apart manner, the magnetic circuit will be twisted in the X-axis direction when it is switched between the first magnetizer 2z1 and the second magnetizer 2z3, and an X-axis magnetic field component will be generated at the position of the third magnetic induction unit (2z2a, 2z2b, 2z2c, 2z2d). The double-layer spaced soft magnetic array vertical detection structure (i.e., the magnetic field measurement region 2z) adopted by the present application solves the problems of uneven magnetic field distribution, severe sensitivity loss, low accuracy, and high noise in the measurement direction of a single-layer array of strip-shaped soft magnetic sheets, and enhances the magnetic concentration effect and magnetic field uniformity, thereby achieving higher magnetic field conversion efficiency, improving sensitivity, improving overall accuracy, sensitivity, and stability of the triaxial sensor, and reducing noise.

In some optional embodiments, the sensor further comprises: first magnetic shielding magnetic induction units (2x2b, 2x2d); the projections of the first magnetic shielding magnetic induction units (2x2b, 2x2d) on the first substrate 1a are located within the magnetic flux guiding region of the third magnetizer 2x1; and the sensor forms a second magnetic signal output circuit for detecting the magnetic induction intensity in the second direction on the basis of the first magnetic induction unit (2x2a or 2x2c) located in the second air gap region and the first magnetic shielding magnetic induction unit (2x2b or 2x2d).

If the direction of the external magnetic field is the positive X-axis direction, a magnetic field to be measured is concentrated and amplified by the soft magnetic metal material structure (the third magnetizer 2x1) to form a magnetic circuit, what the first magnetic induction unit (2x2a or 2x2c) detects is a magnetic field along the positive X-axis direction after being concentrated and amplified at the second air gap of the soft magnetic metal material structure (the third magnetizer 2x1), and the first magnetic shielding magnetic induction unit (2x2b or 2x2d) detects a magnetic field shielded and weakened by the soft magnetic metal material structure (the third magnetizer 2x1). Therefore, the resistance value of the first magnetic induction unit (2x2a or 2x2c) decreases, while the resistance value of the first magnetic shielding magnetic induction unit (2x2b or 2x2d) remains approximately unchanged, and a differential full-bridge structure or a differential half-bridge structure can be used to sense the magnetic field in the X-axis direction and generate a differential voltage signal. In addition, an open-loop signal conditioning circuit can also be used to perform conditioning and amplification, temperature compensation, and linearity correction on the generated differential voltage signal to form an output signal (the first conditioned signal) of the second magnetic signal output circuit used to detect the second direction (i.e., the X-axis direction); or a closed-loop magnetic field feedback structure can be formed by a closed-loop signal conditioning circuit, a magnetic field feedback coil, and a "first magnetic induction unit (2x2a or 2x2c) and a first magnetic shielding magnetic induction unit (2x2b or 2x2d)," the generated differential voltage signal is amplified by the closed-loop signal conditioning circuit, then a feedback magnetic field is generated by the magnetic field feedback coil to achieve dynamic magnetic field balance, and the feedback current of the magnetic field feedback coil is sampled to form an output signal (the second conditioned signal) of the second magnetic signal output circuit used to detect the second direction (i.e., the X-axis direction).

In some optional embodiments, the fourth magnetizer 2y1 (2yla and 2ylb, and FIG. 2 only takes 2ylb as an example and shows all parts included in the fourth magnetizer 2ylb) comprises: a fourth magnetic field input region 2ya in the first direction and located at two ends of the fourth magnetizer 2y1 and a fourth magnetic field conversion region 2yb located between two ends of the fourth magnetizer 2y1; the fourth magnetic field conversion region 2yb comprises a fourth magnetic field conversion magnetic circuit 2yc in the second direction; wherein the fourth magnetic field conversion magnetic circuit 2yc has the third air gap.

Here, the direction of the fourth magnetic field input region refers to the direction of the magnetic induction intensity entering the fourth magnetic field input region 2ya, and the fourth magnetic field conversion magnetic circuit in the second direction is used to convert the "magnetic induction intensity to be measured in the first direction entering the fourth magnetic field input region 2ya" to the magnetic induction intensity in the second direction, and then realizes, on the basis of the magnetic induction unit with the "magnetic induction sensitivity direction being the second direction," the measurement of the magnetic induction intensity in the first direction.

In some optional embodiments, the third air gap comprises a third conversion air gap and a fourth conversion air gap; the fourth magnetic field conversion magnetic circuit 2yc comprises a third conversion magnetic circuit 2yc1 and a fourth conversion magnetic circuit 2yc2 that are adjacent; the third conversion magnetic circuit 2yc1 has the third conversion air gap, and the fourth conversion magnetic circuit 2yc2 has the fourth conversion air gap; and the sensor forms a first magnetic signal output circuit for detecting the magnetic induction intensity in the first direction on the basis of a third conversion magnetic induction unit 2y2a and a fourth conversion magnetic induction unit 2y2b; wherein the third conversion magnetic induction unit 2y2a and the fourth conversion magnetic induction unit 2y2b are located in the air gap regions of the third conversion air gap and the fourth conversion air gap, respectively.

The magnetic field measurement region 2y comprises the fourth magnetizer 2y1 made of a soft magnetic metal material having high permeability. As shown in FIG. 1, in this embodiment, the magnetic field measurement region 2y in the Y-axis direction of the multi-axis magnetic field sensor comprises the fourth magnetic field input region 2ya in the first direction and located at two ends of the fourth magnetizer 2y1 and the fourth magnetic field conversion region 2yb located between two ends of the fourth magnetizer 2y1, and the fourth magnetic field conversion region 2yb comprises the fourth magnetic field conversion magnetic circuit 2yc in the second direction; wherein the fourth magnetic field conversion magnetic circuit 2yc has the third air gap. The fourth magnetizer 2y1 can concentrate the magnetic flux of the input magnetic field in the detection direction and twist the magnetic circuit at the corner to generate a magnetic field component perpendicular to the input magnetic field.

The description takes the direction of the external magnetic field being the positive Y-axis direction and the magnetic induction sensitivity directions of the second magnetic induction units (2y2a, 2y2b) both being the positive X-axis direction as an example. At this point, the magnetic circuit conversion region located at the negative Y-axis end of the soft magnetic metal material structure 2y1 concentrates the magnetic flux of the magnetic field to be measured in the positive Y-axis direction and then twists the magnetic circuit at the corner, and generates a magnetic field in the positive X-axis direction at the fourth conversion air gap of the fourth conversion magnetic circuit 2yc2; then, the soft magnetic metal material structure 2y1 uses a magnetic circuit conversion region with a U-shaped corner to twist the magnetic circuit in the positive X-axis direction to the negative X-axis direction, and generates a magnetic field in the negative X-axis direction at the third conversion air gap of the third conversion magnetic circuit 2yc1, and finally, the magnetic circuit is twisted back to the positive Y-axis direction through the magnetic circuit conversion region with an L-shaped corner at the positive Y-axis end of the soft magnetic metal material structure 2y1 to achieve symmetry in the measurement of the magnetic field in the positive and negative Y-axis directions. The second magnetic induction units (2y2a, 2y2b) and the third magnetic induction units (2z2a, 2z2b, 2z2c, 2z2d) are located in the same passivation layer and can be prepared using the same magnetoresistive thin film deposition process.

FIG. 4 is a simulation diagram of a second type of magnetic flux path provided in an embodiment of the present application. Specifically, FIG. 4 is a simulation diagram of the magnetic flux path after a magnetic field to be measured in the positive Y-axis direction is applied to the magnetic field measurement region 2y in the Y-axis direction in the embodiment provided in FIG. 1. It can be seen that the soft magnetic metal material structure (the fourth magnetizer 2y1) has significantly concentrated the magnetic flux and twisted the magnetic circuit of the magnetic field to be measured in the positive Y-axis direction, and has generated distinct components in the opposite X-axis directions at the positions of the second magnetic induction units 2y2a and 2y2b. Therefore, the second magnetic induction units 2y2a and 2y2b with both sensitivity directions being the positive X-axis direction can form a push-pull half-bridge structure or a differential half-bridge structure formed on the basis of additional resistors to sense a magnetic field in the Y-axis direction and generate a differential voltage signal. In addition, an open-loop signal conditioning circuit can also be used to perform conditioning and amplification, temperature compensation, and linearity correction on the generated differential voltage signal to form an output signal (the first conditioned signal) of the first magnetic signal output circuit used to detect the first direction (i.e., the Y-axis direction); or a closed-loop magnetic field feedback structure can be formed by a closed-loop signal conditioning circuit, a magnetic field feedback coil, and a second magnetic induction unit (2y2a, 2y2b), the generated differential voltage signal is amplified by the closed-loop signal conditioning circuit, then a feedback magnetic field is generated by the magnetic field feedback coil to achieve dynamic magnetic field balance, and the feedback current of the magnetic field feedback coil is sampled to form an output signal (the second conditioned signal) of the first magnetic signal output circuit used to detect the first direction (i.e., the Y-axis direction). The magnetic field feedback coil is a coil wound around in the XY plane on the second substrate 1b.

In the specific implementation of the multi-axis magnetic field sensor corresponding to FIG. 1, the measurement of the magnetic field to be measured in three directions, i.e., X-axis, Y-axis, and Z-axis, can be realized on the basis of the same substrate (the first substrate 1a), and it can achieve single-chip integrated manufacturing, a small size, and good stability. In addition, the embodiments of the present application can achieve measurements of all X, Y, and Z axes by using only magnetic induction units having the same sensitivity direction. Therefore, magnetoresistive thin films can be fabricated on the same layer at one time, which reduces the complexity of the operation steps, facilitates production, and has the advantages of good consistency, small temperature drift, high precision, good stability, and the ability to fabricate single chips. The Z-axis double-layer spaced soft magnetic array detection structure (magnetic field measurement structure in the Z-axis direction) used in the present application has the characteristics of high sensitivity and low noise compared with the prior art.

It can be seen that the multi-axis magnetic field sensor provided in the present application forms a magnetic signal output circuit for measuring different magnetic induction intensity directions through magnetic induction units arranged in the corresponding air gap regions. Since the magnetic induction units in the same passivation layer have the same magnetic induction sensitivity direction, the multi-axis magnetic field sensor provided in the present application can be fabricated on a single chip, and moreover, the fabricated multi-axis magnetic field sensor has better stability and higher accuracy, which solves the "technical problems that existing triaxial magnetic field sensors have poor accuracy and are difficult to achieve single-chip integrated manufacturing."

As shown in FIG. 2, this multi-axis magnetic field sensor is realized on the basis of a dual-substrate structure with no groove. In this embodiment, the soft magnetic metal material structures 2x1a and 2xlb used by the magnetic field measurement region 2x in the X-axis direction are symmetrically distributed about the XY plane on the first substrate 1a and the second substrate 1b; and the soft magnetic metal material structures 2yla and 2ylb used in the magnetic field measurement region 2y in the Y-axis direction are symmetrically distributed about the XY plane on the first substrate 1a and the second substrate 1b. The multi-axis magnetic field sensor comprises three strip-shaped soft magnetic metal materials (the first magnetizers 2z1) formed on the first substrate 1a by means of deposition and semiconductor micromachining for detecting the magnetic induction intensity in the Z-axis direction, and the multiple first magnetizers 2z1 are spaced apart in the X-axis direction. After polishing the surface of the first magnetizer 2z1 using the chemical mechanical polishing (CMP) process and depositing a passivation layer, a magnetoresistive (MR) thin film is deposited on the surface of the passivation layer, and the third magnetic induction unit (2z2a, 2z2b, 2x2c, and 2z2d) is formed by means of semiconductor patterning micromachining. After depositing a passivation layer above the third magnetic induction unit (2z2a, 2z2b, 2x2c, and 2z2d) again to protect the magnetoresistive thin film, two strip-shaped soft magnetic metal materials (the second magnetizers 2z3) for detecting the magnetic induction intensity in the Z-axis direction are formed above the passivation layer by means of deposition and semiconductor micromachining, and the multiple second magnetizers 2z3 are spaced apart in the X-axis direction. The magnetoresistive (MR) thin film adopted by the third magnetic induction unit can be a tunnel magnetoresistor (TMR). By using a single-chip packaging process and by adding lead pads, circuits, and mechanical support housing by means of wafer-level packaging (WLP) and through silicon via (TSV) processes, the first substrate 1a and the second substrate 1b are arranged opposite each other with respect to the plane where the tunnel magnetoresistor (TMR) is located, and are then packaged. FIG. 2 shows a case where no overlapping region exists between the projections of the first magnetizer 2z1 and the second magnetizer 2z3 on the first substrate. The vertical projections of the magnetic induction units 2z2a, 2z2b, 2z2c, and 2z2d in the Z-axis direction (i.e., the projections of the magnetic induction units 2z2a, 2z2b, 2z2c, and 2z2d on the first substrate 1a) are located in a region in which soft magnetic metal materials of the first magnetizer 2z1 and the second magnetizer 2z3 are spaced apart.

It should be noted that the structures of the magnetic field measurement region 2x in the X-axis direction and the magnetic field measurement region 2y in the Y-axis direction in the present application can be interchanged. For example, after rotating the XY plane where the first base 1a is located in this embodiment by 90 degrees around the Z-axis, the original magnetic field measurement region 2x in the X-axis direction can be directly used as the magnetic field measurement region 2y in the Y-axis direction, and the original magnetic field measurement region 2y in the Y-axis direction can be directly used as the magnetic field measurement region 2x in the X-axis direction, while the magnetic field measurement region 2z in the Z-axis direction is not affected.

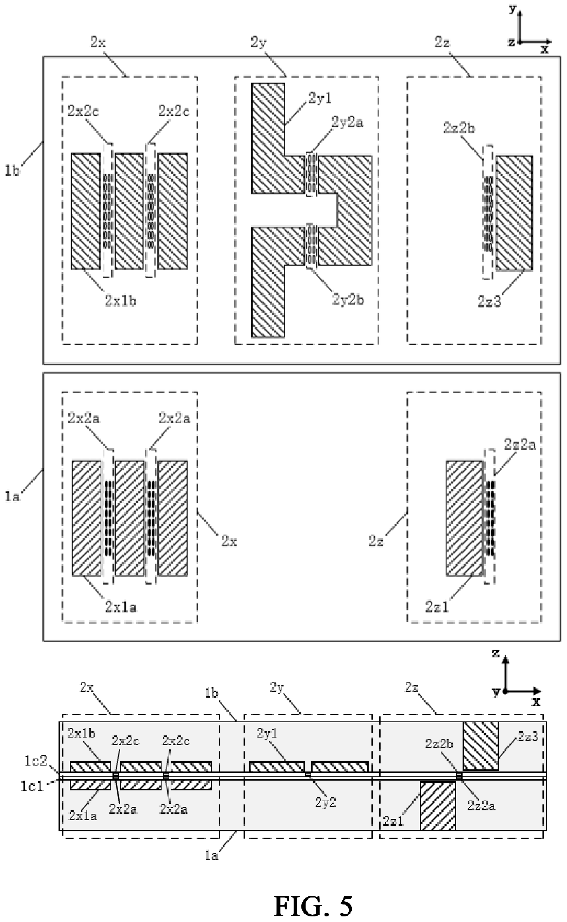

FIG. 5 is a structural schematic diagram of a third type of multi-axis magnetic field sensor provided in an embodiment of the present application. Specifically, the upper part of FIG. 5 shows a structural schematic diagram of the projection of "the component between the passivation layer 1c2 and the second substrate 1b" in the multi-axis magnetic field sensor on the plane (XY plane) where the second substrate 1b is located, the middle part of FIG. 5 shows a structural schematic diagram of the projection of "the component between the passivation layer 1c1 and the first substrate 1a" in the multi-axis magnetic field sensor on the plane (XY plane) where the first substrate 1a is located, and the lower part of FIG. 5 shows a structural schematic diagram of the projection of the multi-axis magnetic field sensor on the XZ plane (with the plane where the first substrate 1a or the second substrate 1b is located as the XY plane).

This embodiment uses two substrates, namely the first substrate 1a and the second substrate 1b located on the XY plane. The magnetic field measurement region 2z in the Z-axis direction senses the magnetic field in the Z-axis direction to be measured, the magnetic field measurement region 2x in the X-axis direction senses the magnetic field in the X-axis direction, and the magnetic field measurement region 2y in the Y-axis direction senses the magnetic field in the Y-axis direction. As shown in FIG. 5, the first magnetizer 2z1 is arranged on the first substrate 1a; the second magnetizer 2z3 is arranged on the second substrate 1b; the third magnetizer 2x1 comprises 2xla and 2x1b, wherein 2xla is arranged on the first substrate 1a and 2x1b is arranged on the second substrate 1b; and the fourth magnetizer 2y1 is arranged on the second substrate 1b.

For the magnetic field measurement region 2z in the Z-axis direction, as shown by the XZ section in FIG. 5, magnetoresistive (MR) thin films using tunnel magnetoresistors (TMR) are deposited on the surfaces of the first substrate 1a and the second substrate 1b, respectively, the third magnetic induction units 2z2a and 2z2b are formed by means of semiconductor patterning micromachining, respectively, and then, a passivation layer is deposited to protect the magnetoresistive thin films. Grooves are formed on the sides of the first substrate 1a and the second substrate 1b away from the magnetoresistive (MR) thin films, respectively, using the backside deep reactive ion etching (DRIE) process, a soft magnetic metal material is deposited in the grooves and polished using the chemical mechanical polishing (CMP) process, the first magnetizer 2z1 is formed in the first substrate 1a, and the second magnetizer 2z3 is formed in the second substrate 1b. By using a single-chip packaging process and by adding lead pads, circuits, and mechanical support housing by means of wafer-level packaging (WLP) and through silicon via (TSV) processes, the first substrate 1a and the second substrate 1b are arranged opposite each other with respect to the plane where the tunnel magnetoresistor (TMR) is located, and are then packaged, so that the packaged third magnetic induction units 2z2a and 2z2b have opposite sensitivity directions, which are the positive X-axis direction and the negative X-axis direction, respectively. In addition, as shown in FIG. 5, the soft magnetic metal materials in the first magnetizer 2z1 and the second magnetizer 2z3 are spaced apart in the X-axis direction, and their projections in the Z-axis direction do not overlap; and the projections of the third magnetic induction units 2z2a and 2z2b in the Z-axis direction are located in a region in which soft magnetic metal materials of the first magnetizer 2z1 and the second magnetizer 2z3 are spaced apart. It should be noted that, since the sensitivity directions of the third magnetic induction units 2z2a and 2z2b are opposite after packaging, the first substrate 1a and the second substrate 1b in this embodiment are each etched with only one groove, that is, the first magnetizer 2z1 and the second magnetizer 2z3 are each made of only one strip of soft the magnetic metal material; in practical applications, more than one groove distributed at intervals can also be etched as needed. Since the backside DRIE process is mainly used to enhance the magnetic concentration effect and improve sensitivity, and its measurement principle is basically the same as that of the aforementioned embodiments, it will not be described in detail here.

Specifically, the description takes the magnetic field to be measured being in the positive Z-axis direction, the sensitivity direction of the third magnetic induction unit 2z2a being the positive X-axis direction, and the sensitivity direction of the magnetic induction unit 2z2b being the negative X-axis direction as an example, in which case the X-axis magnetic field component after conversion is in the positive X-axis direction at the positions of the third magnetic induction units 2z2a and 2z2b, the resistance value of the third magnetic induction unit 2z2a decreases, and the resistance value of the third magnetic induction unit 2z2b increases. Therefore, a push-pull half-bridge structure or a differential half-bridge structure formed with additional reference resistors can be used to sense a magnetic field in the Z-axis direction and generate a differential voltage signal. In addition, an open-loop signal conditioning circuit can also be used to perform conditioning and amplification, temperature compensation, and linearity correction on the generated differential voltage signal to form an output signal (the first conditioned signal) of the third magnetic signal output circuit used to detect the third direction (i.e., the Z-axis direction); or a closed-loop magnetic field feedback structure can be formed by a closed-loop signal conditioning circuit, a magnetic field feedback coil, and a third magnetic induction unit (2z2a, 2z2b), the generated differential voltage signal is amplified by the closed-loop signal conditioning circuit, then a feedback magnetic field is generated by the magnetic field feedback coil to achieve dynamic magnetic field balance, and the feedback current of the magnetic field feedback coil is sampled to form an output signal (the second conditioned signal) of the third magnetic signal output circuit used to detect the third direction. The magnetic field feedback coil is a coil wound around in the XY plane on the second substrate 1b.

For the magnetic field measurement region 2x in the X-axis direction, magnetoresistive (MR) thin films are deposited on the surfaces of the first substrate 1a and the second substrate 1b, respectively, the first magnetic induction units 2x2a and 2x2c are formed by means of semiconductor patterning micromachining, respectively, and then, a passivation layer is deposited to protect the magnetoresistive thin films. As shown in FIG. 5, grooves spaced apart are etched on the first substrate 1a and the second substrate 1b, respectively, and a soft magnetic metal material having high permeability is deposited in the grooves to form strip-shaped soft magnetic metal material structures 2x1a and 2x 1b that are spaced apart. After packaging, the soft magnetic metal material structures 2x1a and 2x1b are symmetrically distributed about the XY plane within the first substrate 1a and the second substrate 1b. The first magnetic induction unit 2x2a and the third magnetic induction unit 2z2a are located on the same layer and use the same magnetoresistive thin film deposition process, and their sensitivity directions are both in the positive X-axis direction; the first magnetic induction unit 2x2c and the third magnetic induction unit 2z2b are located on the same layer and use the same magnetoresistive thin film deposition process, and their sensitivity directions are both in the negative X-axis direction; wherein the projection of the first magnetic induction units 2x2a and 2x2c along the Z-axis direction are located in the spacing air gaps of the region in which the soft magnetic metal materials are spaced apart. The description takes the magnetic field to be measured being in the positive X-axis direction as an example, in which case the magnetic fields at the first magnetic induction units 2x2a and 2x2c are both in the positive X-axis direction, the resistance value of the first magnetic induction unit 2x2a decreases, the resistance value of the first magnetic induction unit 2x2c increases, and a push-pull full-bridge structure or a push-pull half-bridge structure can be used to sense the magnetic field in the X-axis direction and generate a differential voltage signal. In addition, an open-loop signal conditioning circuit can also be used to perform conditioning and amplification, temperature compensation, and linearity correction on the generated differential voltage signal to form an output signal (the first conditioned signal) of the second magnetic signal output circuit used to detect the second direction (i.e., the X-axis direction); or a closed-loop magnetic field feedback structure can be formed by a closed-loop signal conditioning circuit, a magnetic field feedback coil, and "the first magnetic induction units 2x2a and 2x2c," the generated differential voltage signal is amplified by the closed-loop signal conditioning circuit, then a feedback magnetic field is generated by the magnetic field feedback coil to achieve dynamic magnetic field balance, and the feedback current of the magnetic field feedback coil is sampled to form an output signal (the second conditioned signal) of the second magnetic signal output circuit used to detect the second direction.

For the magnetic field measurement region 2y in the Y-axis direction, the same magnetoresistive thin film deposition process is adopted on the surface of the second substrate 1b as on the third magnetic induction unit 2z2b, the second magnetic induction units 2y2a and 2y2b are formed on the same layer, and then, a passivation layer is deposited to protect the magnetoresistive thin films. After packaging, the sensitivity directions of the second magnetic induction units 2y2a and 2y2b are both in the negative X-axis direction. As shown in FIG. 5, grooves are etched on the second substrate 1b, and a soft magnetic metal material having high permeability is deposited in the grooves to form the soft magnetic metal material structure 2y1. The shape of the soft magnetic metal material structure 2y1 in this embodiment is the same as that of the soft magnetic metal material structure 2y1 in the "magnetic field measurement region 2y in the Y-axis direction" in the embodiment corresponding to FIG. 1, with the main difference in that the soft magnetic metal material in the embodiment corresponding to FIG. 1 is deposited above the second substrate 1b, while the soft magnetic metal material in this embodiment is deposited in the grooves inside the second substrate 1b. In this embodiment, the projections of the second magnetic induction units 2y2a and 2y2b along the Z-axis are located within the air gap of the soft magnetic metal material structure 2y1. The description takes the magnetic field to be measured being in the positive Y-axis direction as an example, in which case the resistance value of the second magnetic induction unit 2y2a decreases, while the resistance value of the second magnetic induction unit 2y2b increases. Therefore, a differential full-bridge structure can be formed by connecting the second magnetic induction units 2y2a and 2y2b with reference resistors in series and parallel to sense a magnetic field in the Y-axis direction and generate a differential voltage signal. Furthermore, an open-loop signal conditioning circuit can also be used to perform conditioning and amplification, temperature compensation, and linearity correction on the generated differential voltage signal to form an output signal (the first conditioned signal) of the first magnetic signal output circuit used to detect the first direction (i.e., the Y-axis direction); or a closed-loop magnetic field feedback structure can be formed by a closed-loop signal conditioning circuit, a magnetic field feedback coil, and "the second magnetic induction units 2y2a and 2y2b/the second magnetic induction unit 2y2a and resistors/the second magnetic induction unit 2y2b and resistors," the generated differential voltage signal is amplified by the closed-loop signal conditioning circuit, then a feedback magnetic field is generated by the magnetic field feedback coil to achieve dynamic magnetic field balance, and the feedback current of the magnetic field feedback coil is sampled to form an output signal (the second conditioned signal) of the first magnetic signal output circuit used to detect the first direction.

In summary, the multi-axis magnetic field sensor in the embodiment shown in FIG. 5 uses a single-chip packaging process on two substrates (the first substrate 1a and the second substrate 1b), which is characterized in that the magnetic induction sensitivity directions of the magnetic induction units on the first substrate 1a and the second substrate 1b are opposite during packaging, and they are 180 degrees apart in the XY plane. Therefore, it is easy to form push-pull and differential structures between the two substrates; moreover, the projections of the magnetic induction units on the first substrate 1a and the second substrate 1b on the Z-axis can overlap, thereby improving consistency and accuracy. The packaging method of this embodiment can minimize the Z-axis size, that is, the first magnetizer 2z1 and the first magnetizer 2z3 can each use only one piece of a soft magnetic metal material to form a push-pull half-bridge structure, which is beneficial for reducing the size. Meanwhile, this embodiment adopts the backside deep reactive ion etching (DRIE) process, which can enhance the magnetic concentration effect and improve the sensitivity, and solve the technical problems of low magnetic field conversion efficiency, sensitivity loss, and high noise in the measurement direction of the magnetic flux concentration structures in the prior art.

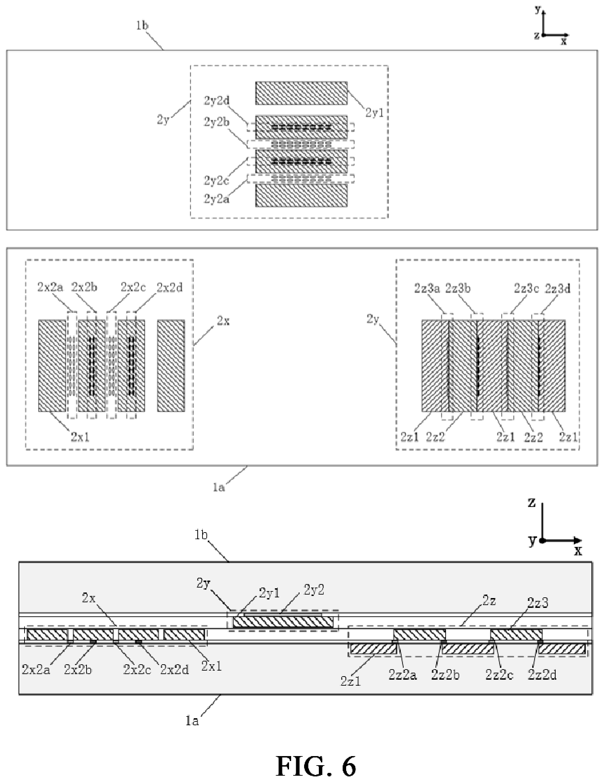

FIG. 6 is a structural schematic diagram of a fourth type of multi-axis magnetic field sensor provided in an embodiment of the present application. Specifically, the upper part of FIG. 6 shows a structural schematic diagram of the projection of "the fourth magnetizer, the second magnetic induction unit, and the second magnetic shielding magnetic induction unit" in the multi-axis magnetic field sensor on the plane (XY plane) where the second substrate 1b is located, the middle part of FIG. 6 shows a structural schematic diagram of the projection of "the first magnetizer, the second magnetizer, the third magnetizer, the first magnetic induction unit, the first magnetic shielding magnetic induction unit, and the third magnetic induction unit" in the multi-axis magnetic field sensor on the plane (XY plane) where the first substrate 1a is located, and the lower part of FIG. 6 shows a structural schematic diagram of the projection of the multi-axis magnetic field sensor on the XZ plane (with the plane where the first substrate 1a or the second substrate 1b is located as the XY plane).

In some optional embodiments, the sensor further comprises: a second magnetic shielding magnetic induction unit; the projection of the second magnetic shielding magnetic induction unit on the substrate is located within the magnetic flux guiding region of the fourth magnetizer; and the sensor forms a first magnetic signal output circuit for detecting the magnetic induction intensity in the first direction on the basis of a second magnetic induction unit located in the second air gap region and the second magnetic shielding magnetic induction unit.

This embodiment uses two substrates, namely the first substrate 1a and the second substrate 1b located on the XY plane. The magnetic field measurement region 2z in the Z-axis direction senses the magnetic field in the Z-axis direction to be measured, the magnetic field measurement region 2x in the X-axis direction senses the magnetic field in the X-axis direction to be measured, and the magnetic field measurement region 2y in the Y-axis direction senses the magnetic field in the Y-axis direction to be measured. As shown in FIG. 6, the first magnetizer 2z1 is arranged on the first substrate 1a, and the second magnetizer 2z3, the third magnetizer 2x1, and the fourth magnetizer 2y1 are arranged on the passivation layer.

For the magnetic field measurement region 2z in the Z-axis direction, as shown by the XZ section in FIG. 6, grooves spaced apart in the X-axis direction are etched on the first substrate 1a, respectively, and a soft magnetic metal material having high permeability is deposited in the grooves to form strip-shaped regions of the soft magnetic metal material that are spaced apart, which are polished using the chemical mechanical polishing (CMP) process to form the first magnetizer 2z1. Magnetoresistive (MR) thin films using tunnel magnetoresistors (TMR) are deposited above the first magnetizer 2z1, the third magnetic induction units 2z2a, 2z2b, 2z2c, and 2z2d are formed by means of semiconductor patterning micromachining, respectively, and then, a passivation layer is deposited to protect the magnetoresistive thin films. A soft magnetic metal material is further deposited above the passivation layer, and another layer of strip-shaped soft magnetic metal materials spaced apart that are spaced apart in the X-axis direction with the first magnetizer 2z1 is formed by means of semiconductor micromachining to form the second magnetic material 2z3. As shown in FIG. 6, the projection of the magnetoresistive (MR) thin film along the Z-axis direction is located at a position less than 1/2 of the soft magnetic metal material inside the groove edge; the projections of the first magnetizer 2z1 and the second magnetizer 2z3 in the Z-axis direction (i.e., their projections on the substrate) have a partially overlapping region, and the overlapping region of the projections of the first magnetizer 2z1 and the second magnetizer 2z3 on the substrate is less than half of the magnetic flux guiding region of the magnetizer (the magnetic flux guiding region of the first magnetizer 2z1 or the magnetic flux guiding region of the second magnetizer 2z3).

Specifically, the description takes the sensitivity directions of the third magnetic induction units 2z2a, 2z2b, 2z2c, and 2z2d being the positive X-axis direction and the magnetic field to be measured being in the positive Z-axis direction as an example, in which case the X-axis magnetic field component after conversion is in the positive X-axis direction at both positions of the third magnetic induction units 2z2a and 2z2c and in the negative X-axis direction at both positions of the third magnetic induction units 2z2b and 2z2d, the resistance values of the third magnetic induction units 2z2a and 2z2c decrease, and the resistance values of the third magnetic induction units 2z2b and 2z2d increase. Therefore, a push-pull full-bridge structure can be used to sense a magnetic field in the Z-axis direction and generate a differential voltage signal. In addition, an open-loop signal conditioning circuit can also be used to perform conditioning and amplification, temperature compensation, and linearity correction on the generated differential voltage signal to form an output signal (the first conditioned signal) of the second magnetic signal output circuit used to detect the second direction (i.e., the X-axis direction).

For the magnetic field measurement region 2x in the X-axis direction, magnetoresistive (MR) thin films are deposited on the surface of the first substrate 1a, the first magnetic induction units (2x2a, 2x2c) and the first magnetic shielding magnetic induction units (2x2b, 2x2d) are formed by means of semiconductor patterning micromachining, and then, a passivation layer is deposited to protect the magnetoresistive thin films. The first magnetic induction units, the first magnetic shielding magnetic induction units, and the third magnetic induction units (2z2a, 2z2b, 2z2c, and 2z2d) are located on the same layer and use the same magnetoresistive thin film deposition process, and their sensitivity directions are all in the positive X-axis direction. As shown in FIG. 6, the third magnetizer 2x1 and the second magnetizer 2z3 are located on the same layer and use the same deposition process, and strip-shaped regions that are spaced apart are formed above the passivation layer of the magnetoresistive thin films by means of deposition and semiconductor micromachining; the projections of the first magnetic induction units 2x2a and 2x2c along the Z-axis direction are located in the spacing air gaps of the region in which the soft magnetic metal materials are spaced apart, and the projections of the first magnetic shielding magnetic induction units 2x2b and 2x2d along the Z-axis direction are located in the projection coverage region of the soft magnetic metal material. The description takes the magnetic field to be measured being in the positive X-axis direction as an example, in which case the resistance values of the first magnetic induction units 2x2a and 2x2c decrease, the resistance values of the first magnetic shielding magnetic induction unit 2x2b and 2x2d remains approximately unchanged, and a differential full-bridge structure can be used to sense the magnetic field in the X-axis direction and generate a differential voltage signal.

For the magnetic field measurement region 2y in the Y-axis direction, the second magnetic induction units (2y2a, 2y2b), the second magnetic shielding magnetic induction units (2y2c, 2y2d), and the fourth magnetizer 2y1 are formed using exactly the same process. 2y2 represents a magnetic induction unit in the magnetic field measurement region 2y in the Y-axis direction (in this embodiment, it comprises: the second magnetic induction units 2y2a, 2y2b and the second magnetic shielding magnetic induction units 2y2c, 2y2d). It should be noted that, when the first substrate 1a and the second substrate 1b are arranged opposite each other with respect to the plane where the tunnel magnetoresistor (TMR) is located and are then packaged by using a single-chip packaging process and by adding lead pads, circuits, and mechanical support housing by means of wafer-level packaging (WLP) and through silicon via (TSV) processes, it is necessary to make the magnetic induction sensitivity direction of the packaged second magnetic induction unit perpendicular to the magnetic induction sensitivity direction of "the first magnetic induction unit or the third magnetic induction unit," and as shown in FIG. 6 in this embodiment, the magnetic induction sensitivity direction of the second magnetic induction unit is in the negative Y-axis direction, while the magnetic induction sensitivity direction of the first magnetic induction unit or the third magnetic induction unit is in the positive X-axis direction.

In summary, the multi-axis magnetic field sensor provided in this embodiment adopts a single-chip packaging process on two substrates 1, which is characterized in that the sensitivity directions of the magnetic induction units on the first substrate 1a and the second substrate 1b are perpendicular during packaging and differ by 90 degrees in the XY plane. Therefore, the magnetic field measurement region 2x in the X-axis direction and the magnetic field measurement region 2z in the X-axis direction can adopt the same measurement structure, leading to a simple structure and reduced costs.

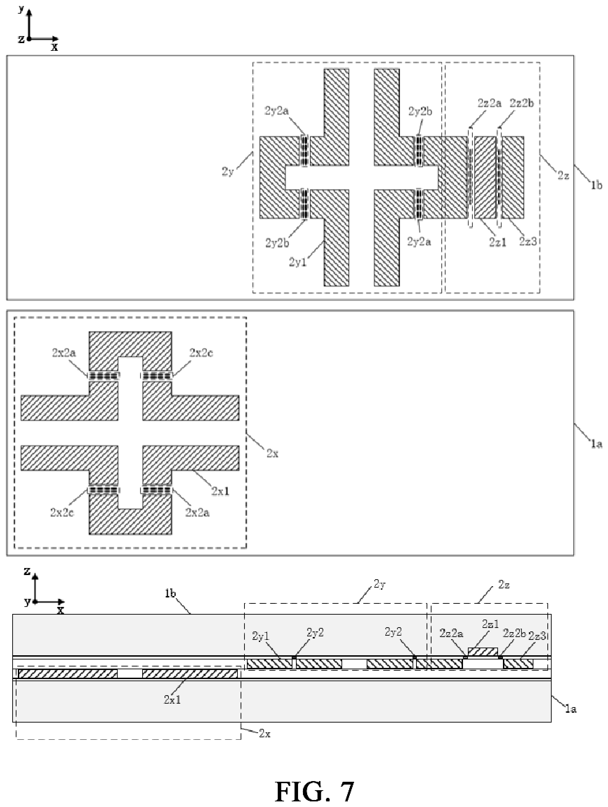

FIG. 7 is a structural schematic diagram of a fifth type of multi-axis magnetic field sensor provided in an embodiment of the present application. Specifically, the upper part of FIG. 7 shows a structural schematic diagram of the projections of "the first magnetic induction unit, the first magnetic shielding magnetic induction unit, and the fourth magnetic induction unit" in the multi-axis magnetic field sensor on the plane (XY plane) where the first substrate 1a is located, the middle part of FIG. 7 shows a structural schematic diagram of the projections of "the second magnetic induction unit, the second magnetic shielding magnetic induction unit, the third magnetic induction unit, the first magnetizer, the second magnetizer, and the third magnetizer" in the multi-axis magnetic field sensor on the plane (XY plane) where the second substrate 1b is located, and the lower part of FIG. 7 shows a structural schematic diagram of the projection of the multi-axis magnetic field sensor on the XZ plane (with the plane where the first substrate 1a or the second substrate 1b is located as the XY plane). Here, 2y2 represents a magnetic induction unit in the magnetic field measurement region 2y in the Y-axis direction (in this embodiment, it comprises: the second magnetic induction units 2y2a, 2y2b).

In some optional embodiments, the third magnetizer 2x1 comprises: a third magnetic field input region in the second direction and located at two ends of the third magnetizer 2x1 and a third magnetic field conversion region located between two ends of the third magnetizer; the third magnetic field conversion region comprises a third magnetic field conversion magnetic circuit in the first direction; wherein the third magnetic field conversion magnetic circuit has the second air gap.

In some optional embodiments, the second air gap comprises a first conversion air gap and a second conversion air gap; the third magnetic field conversion magnetic circuit comprises a first conversion magnetic circuit and a second conversion magnetic circuit that are adjacent; the first conversion magnetic circuit has the first conversion air gap, and the second conversion magnetic circuit has the second conversion air gap; and the sensor forms a second magnetic signal output circuit for detecting the magnetic induction intensity in the second direction on the basis of a first conversion magnetic induction unit and a second conversion magnetic induction unit; wherein the first conversion magnetic induction unit and the second conversion magnetic induction unit are located in the air gap regions of the first conversion air gap and the second conversion air gap, respectively.

This embodiment uses two substrates, namely the first substrate 1a and the second substrate 1b located on the XY plane. The magnetic field measurement region 2z in the Z-axis direction senses the magnetic field in the Z-axis direction to be measured, the magnetic field measurement region 2x in the X-axis direction senses the magnetic field in the X-axis direction to be measured, and the magnetic field measurement region 2y in the Y-axis direction senses the magnetic field in the Y-axis direction to be measured. As shown in FIG. 7, the first magnetizer 2z1 is arranged on the first substrate 1a, and the second magnetizer 2z3, the third magnetizer 2x1, and the fourth magnetizer 2y1 are arranged on the passivation layer.

For the magnetic field measurement region 2x in the X-axis direction, a magnetoresistive (MR) thin film, which is an anisotropic magnetoresistor (AMR), is deposited on the surface of the first substrate 1a, the first magnetic induction units (2x2a, 2x2c) are formed by means of semiconductor patterning micromachining, and the magnetic induction sensitivity directions of the first magnetic induction units (2x2a, 2x2c) located on the first substrate 1a in this embodiment are all in the negative Y-axis direction. A passivation layer is then deposited to protect the magnetoresistive film, and a soft magnetic metal material is further deposited above the passivation layer to form a third magnetizer 2x1 through semiconductor micromachining. Here, the third magnetizer 2x1 in this embodiment comprises a magnetic circuit conversion region of a soft magnetic metal material with corners, and its shape is similar to a combination of the shapes of the fourth magnetizer 2y1 in the embodiment corresponding to FIG. 2. Specifically as shown by the XY section in FIG. 7, the soft magnetic metal material structure 2x1 contains two soft magnetic metal material structures that are parallel to the XY plane and symmetrical about the X-axis, and therefore two parallel symmetrical magnetic flux paths can be formed. For the half of the soft magnetic metal material structure 2x1 that is in the positive Y-axis direction, the description takes the magnetic field to be measured being in the positive X-axis direction as an example, in which case the magnetic circuit conversion region with an L-shaped corner and located at the negative X-axis end of the soft magnetic metal material structure 2x1 concentrates the magnetic flux of the magnetic field to be measured in the positive X-axis direction and then twists the magnetic circuit at the corner, generates a magnetic field in the positive Y-axis direction, and passes it through the air gap where the Z-axis projection of the first magnetic induction unit 2x2a is located; then, the soft magnetic metal material structure 2x1 uses a magnetic circuit conversion region with a U-shaped corner to twist the magnetic circuit in the positive Y-axis direction to the negative Y-axis direction, and passes it through the air gap where the Z-axis projection of the second magnetic induction unit 2x2c is located, and finally, the magnetic circuit is twisted back to the positive X-axis direction through the magnetic circuit conversion region with an L-shaped corner at the positive X-axis end of the soft magnetic metal material structure 2x1 to achieve symmetry in the measurement of the magnetic field in the positive and negative X-axis directions. Therefore, the half of the soft magnetic metal material structure 2x1 that is in the positive Y-axis direction is connected in series to the same magnetic circuit. The half of the soft magnetic metal material structure 2x1 that is in the negative Y-axis direction is symmetrical about the X-axis with respect to the half o soft magnetic metal material structure that is in the positive Y-axis direction. That is, the magnetic circuit after the magnetic field to be measured in the positive X-axis direction is distorted by the magnetic circuit conversion region is in the positive Y-axis direction at the air gap where the Z-axis projection of the first magnetic induction unit 2x2a is located, and is in the negative Y-axis direction at the air gap where the Z-axis projection of the first magnetic induction unit 2x2c is located. The half of the soft magnetic metal material structure 2x1 that is in the positive Y-axis direction is connected in series to the same magnetic circuit. Therefore, the two magnetic circuits formed by the half of the soft magnetic metal material structure 2x1 that is in the positive Y-axis direction and the half thereof in the negative Y-axis direction are connected in parallel.

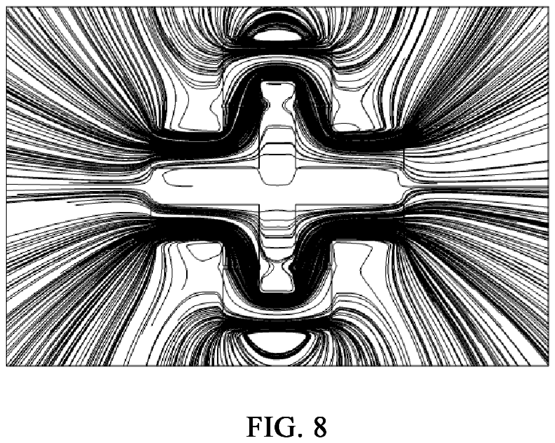

FIG. 8 is a simulation diagram of a third type of magnetic flux path provided in an embodiment of the present application. Specifically, FIG. 8 is a simulation diagram of the magnetic flux path after a magnetic field to be measured in the positive X-axis direction is applied to the magnetic field measurement region 2x in the Z-axis direction in the embodiment provided in FIG. 7. It can be seen that the soft magnetic metal material structure 2x1 has significantly concentrated the magnetic flux and twisted the magnetic circuit of the magnetic field to be measured in the positive X-axis direction, forms two magnetic the flux paths that are in parallel and symmetrical about the X-axis direction, and generates distinct components in the opposite Y-axis directions at the positions of the first magnetic induction units 2x2a and 2x2c. Therefore, the magnetic induction units 2x2a and 2x2c with both sensitivity directions being the negative Y-axis direction can form a push-pull full-bridge structure to sense a magnetic field in the X-axis direction and generate a differential voltage signal.

The measurement principle of the magnetic field measurement region 2y in the Y-axis direction is similar to that of the magnetic field measurement region 2x in the X-axis direction, and the magnetic field measurement region 2y and the magnetic field measurement region 2z in the Z-axis direction share some of the soft magnetic metal material. Specifically, for the magnetic field measurement region 2y in the Y-axis direction, a magnetoresistive (MR) thin film is deposited on the surface of the second substrate 1b and then processed by means of semiconductor patterning micromachining, as shown by the XY section in FIG. 7, to form the second magnetic induction units (2y2a, 2y2b) with the sensitivity direction in the positive X-axis direction, a passivation layer is then deposited to protect the magnetoresistive thin film, and then a soft magnetic metal material is further deposited above the passivation layer to form the fourth magnetizer 2y1 through semiconductor micromachining. The second magnetic induction units (2y2a and 2y2b) form a push-pull full-bridge structure to sense a magnetic field in the Y-axis direction and generate a differential voltage signal.

For the magnetic field measurement region 2z in the Z-axis direction, the third magnetic induction units (2z2a, 2z2b) and the second magnetic induction units (2y2a and 2y2b) are located on the same layer and use the same magnetoresistive thin film deposition process, the magnetic induction units 2z2a and 2z2b with both sensitivity directions being the positive X-axis direction are formed as shown in FIG. 7, and then a passivation layer is deposited to protect the magnetoresistive thin films. It should be noted that the second magnetizer 2z3 and the fourth magnetizer 2y1 in this embodiment share a portion of the soft magnetic metal material. That is, the soft magnetic metal material at the positive X-axis end of the soft magnetic metal material structure 2y1 in FIG. 7 also serves as the soft magnetic metal material at the negative X-axis end of the second magnetizer 2z3. Therefore, for the magnetic field measurement region 2z in this embodiment, after forming the third magnetic induction units 2z2a and 2z2b protected by the passivation layer, as shown in FIG7, a groove is etched at a position on the second substrate 1b at a distance in the positive X-axis direction from the above-mentioned partially shared soft magnetic metal material, and a soft magnetic metal material having high permeability is deposited in the groove to form a strip-shaped region of the soft magnetic metal material that constitutes the first magnetizer 2z1. The second magnetizer 2z3 and the soft magnetic metal material structure 2y1 are located on the same layer and use the same deposition and semiconductor microfabrication processes. In addition to the aforementioned partially shared soft magnetic metal material, it also comprises another strip-shaped soft magnetic metal material that is spaced apart from the first magnetizer 2z1 in the positive X-axis direction and located above the magnetoresistive thin film passivation layer. The projection of the third magnetic induction unit 2z2a in the Z-axis direction is located in a spacing between the first magnetizer 2z1 and the aforementioned partially shared soft magnetic metal material; and the projection of the third magnetic induction unit 2z2b in the Z-axis direction is located in a spacing between the first magnetizer 2z1 and the other strip-shaped soft magnetic metal material of the second magnetizer 2z3.

Specifically, the description takes the sensitivity directions of the third magnetic induction units 2z2a and 2z2b being the positive X-axis direction and the magnetic field to be measured being in the positive Z-axis direction as an example, in which case the X-axis magnetic field component after conversion is in the positive X-axis direction at the third magnetic induction unit 2z2a and in the negative X-axis direction at the third magnetic induction unit 2z2b. Therefore, a push-pull half-bridge structure can be used to sense a magnetic field in the Z-axis direction and generate a differential voltage signal. It should be noted in this embodiment that, when the first substrate 1a and the second substrate 1b are arranged opposite each other with respect to the plane where the magnetoresistive (MR) thin film is located and are then packaged by using a single-chip packaging process and by adding lead pads, circuits, and mechanical support housing by means of wafer-level packaging (WLP) and through silicon via (TSV) processes, it is necessary to make the magnetic induction sensitivity direction of the packaged first magnetic induction unit perpendicular to the magnetic induction sensitivity direction of "the second magnetic induction unit or the third magnetic induction unit," and as shown in FIG. 7 in this embodiment, the magnetic induction sensitivity direction of the first magnetic induction unit is in the negative Y-axis direction, while the magnetic induction sensitivity direction of the second magnetic induction unit or the third magnetic induction unit is in the positive X-axis direction.

In summary, the multi-axis magnetic field sensor provided in this embodiment adopts a single-chip packaging process on two substrates 1, which is, like the embodiment corresponding to FIG. 6, characterized in that the sensitivity directions of the magnetic induction units on the first substrate 1a and the second substrate 1b are perpendicular during packaging and differ by 90 degrees in the XY plane. The difference is that the soft magnetic metal material structures 2x1 and 2y1 in this embodiment each adopt two magnetic circuits parallel to the XY plane and symmetrical about the X-axis or Y-axis to form a push-pull full-bridge structure. Its advantage is that only magnetic induction units with the same sensitivity direction are prepared on each substrate at once to realize push-pull bridge measurement on the X, Y, and Z axes. Compared with the ordinary differential full-bridge structure where part of the resistance changes with the magnetic field and part of the resistance is approximately constant, this embodiment has higher sensitivity, better consistency, and higher accuracy. In addition, different detection modules in this embodiment directly share some of the soft magnetic metal material, which helps to save costs and reduce size.

In some optional embodiments, the sensor further comprises: an external magnetic field magnetic induction unit 2A; the distances from the external magnetic field magnetic induction unit 2A to the first magnetizer 2z1, the second magnetizer 2z3, the third magnetizer 2x1, and the fourth magnetizer 2y1 are all greater than a preset distance; and the sensor forms, on the basis of the magnetic induction units and the external magnetic field magnetic induction unit 2A, magnetic signal output circuits for measuring different magnetic induction intensity directions, respectively.

Here, it should be noted that when the distance between the external magnetic field induction unit 2A and the soft magnetic metal material is greater than a third preset distance, the external magnetic field induction unit 2A will be directly affected by an external magnetic field, and the third preset distance can be determined according to the actual magnetic induction range.

In some optional embodiments, the sensor further comprises: a resistor (preferably a fixed resistor); and the sensor forms, on the basis of the magnetic induction units and the resistor, magnetic signal output circuits for measuring different magnetic induction intensity directions, respectively.

The embodiments of the present application further provide a multi-axis magnetic field sensor chip, and the multi-axis magnetic field sensor chip is formed by packaging the multi-axis magnetic field sensor according to any one of the above first aspect by means of wafer-level packaging (WLP) and through silicon via (TSV) processes.

It should be understood that the multi-axis magnetic field sensor chip corresponds to the above-described embodiment of the multi-axis magnetic field sensor, and the specific functional implementation of the multi-axis magnetic field sensor chip can be found in the detailed description of the multi-axis magnetic field sensor above, and to avoid repetition, the detailed description is omitted here.

The functional modules in various embodiments of the present application can be integrated together to form an independent part, or each module can exist independently, or two or more modules can be integrated to form an independent part.

The above description is only an optional implementation of the embodiments of the present application, and the protection scope of the embodiments of the present application is not limited thereto. Any changes or substitutions that can be easily conceived by those skilled in the art within the technical scope disclosed in the embodiments of the present application shall be encompassed within the protection scope of the embodiments of the present application.

## Claims

1. A multi-axis magnetic field sensor, **characterized in that** the sensor comprises:
at least one first magnetizer in a third direction and arranged on a first substrate;
at least one second magnetizer in the third direction and arranged on a passivation layer or a second substrate; the difference between the number of the first magnetizer and the number of the second magnetizer is less than 2, and no overlapping region exists between the projections of the first magnetizer and the second magnetizer on the substrate or the overlapping region is less than half of the magnetic flux guiding region of the magnetizers; wherein the substrate is the first substrate or the second substrate, and the magnetic flux guiding region of the magnetizer is the magnetic flux guiding region of the first magnetizer or the magnetic flux guiding region of the second magnetizer;
a first air gap formed on the basis of the first magnetizer and the second magnetizer;
a third magnetizer in a second direction and arranged on the substrate or the passivation layer, the third magnetizer having a second air gap;
a fourth magnetizer in a first direction and arranged on the substrate or the passivation layer, the fourth magnetizer having a third air gap; wherein the first direction, the second direction, and the third direction are mutually perpendicular;
at least three magnetic induction units located in corresponding air gap regions, respectively;
wherein the air gap regions comprise air gap regions of the first air gap, the second air gap, and the third air gap, and the sensors form, on the basis of the magnetic induction units, magnetic signal output circuits for measuring different magnetic induction intensity directions , respectively; wherein the passivation layer is a passivation protective layer around the magnetic induction units, and the magnetic induction units within the same passivation layer have the same magnetic induction sensitivity direction.

2. The sensor according to claim 1, **characterized in that** the third magnetizer comprises: a third magnetic field input region in the second direction and located at two ends of the third magnetizer and a third magnetic field conversion region located between two ends of the third magnetizer; the third magnetic field conversion region comprises a third magnetic field conversion magnetic circuit in the first direction; wherein the third magnetic field conversion magnetic circuit has the second air gap.

3. The sensor according to claim 2, **characterized in that** the second air gap comprises a first conversion air gap and a second conversion air gap; the third magnetic field conversion magnetic circuit comprises a first conversion magnetic circuit and a second conversion magnetic circuit that are adjacent; the first conversion magnetic circuit has the first conversion air gap, and the second conversion magnetic circuit has the second conversion air gap;
and the sensor forms, on the basis of a first conversion magnetic induction unit and a second conversion magnetic induction unit, a second magnetic signal output circuit for detecting the magnetic induction intensity in the second direction; wherein the first conversion magnetic induction unit and the second conversion magnetic induction unit are located in the air gap regions of the first conversion air gap and the second conversion air gap, respectively.

4. The sensor according to claim 1, **characterized in that** the fourth magnetizer comprises: a fourth magnetic field input region in the first direction and located at two ends of the fourth magnetizer, and a fourth magnetic field conversion region located between two ends of the fourth magnetizer; the fourth magnetic field conversion region comprises a fourth magnetic field conversion magnetic circuit in the second direction; wherein the fourth magnetic field conversion magnetic circuit has the third air gap.

5. The sensor according to claim 4, **characterized in that** the third air gap comprises a third conversion air gap and a fourth conversion air gap; the fourth magnetic field conversion magnetic circuit comprises a third conversion magnetic circuit and a fourth conversion magnetic circuit that are adjacent; the third conversion magnetic circuit has the third conversion air gap, and the fourth conversion magnetic circuit has the fourth conversion air gap;
and the sensor forms a first magnetic signal output circuit for detecting the magnetic induction intensity in the first direction on the basis of a third conversion magnetic induction unit and a fourth conversion magnetic induction unit; wherein the third conversion magnetic induction unit and the fourth conversion magnetic induction unit are located in the air gap regions of the third conversion air gap and the fourth conversion air gap, respectively.

6. The sensor according to claim 1, **characterized in that** the sensor further comprises: a first magnetic shielding magnetic induction unit; the projection of the first magnetic shielding magnetic induction unit on the substrate is located within the magnetic flux guiding region of the third magnetizer;
and the sensor forms a second magnetic signal output circuit for detecting the magnetic induction intensity in the second direction on the basis of a first magnetic induction unit located in the second air gap region and the first magnetic shielding magnetic induction unit.

7. The sensor according to claim 1, **characterized in that** the sensor further comprises: a second magnetic shielding magnetic induction unit; the projection of the second magnetic shielding magnetic induction unit on the substrate is located within the magnetic flux guiding region of the fourth magnetizer;
and the sensor forms a first magnetic signal output circuit for detecting the magnetic induction intensity in the first direction on the basis of a second magnetic induction unit located in the third air gap region and the second magnetic shielding magnetic induction unit.

8. The sensor according to claim 1, **characterized in that** the sensor further comprises: an external magnetic field magnetic induction unit; the distances from the external magnetic field magnetic induction unit to the first magnetizer, the second magnetizer, the third magnetizer, and the fourth magnetizer are all greater than a preset distance;
and the sensor forms, on the basis of the magnetic induction units and the external magnetic field magnetic induction unit, magnetic signal output circuits for measuring different magnetic induction intensity directions, respectively.

9. The sensor according to claim 1, wherein grooves in the substrate are prepared by a backside deep reactive ion etching (DRIE) process, and after depositing a soft magnetic metal material in the grooves, a chemical mechanical polishing (CMP) process is used for polishing.

10. The sensor according to any one of claims 1-9, **characterized in that** the sensor further comprises: an open-loop signal conditioning circuit; the open-loop signal conditioning circuit and the magnetic signal output circuit are electrically connected; the sensor performs conditioning and amplification, temperature compensation, and/or linearity correction on an electrical signal output by the magnetic signal output circuit on the basis of the open-loop signal conditioning circuit to obtain a first conditioned signal; and outputs the first conditioned signal; or,
the sensor further comprises: a closed-loop signal conditioning circuit and a magnetic field feedback coil; the sensor forms a closed-loop magnetic field feedback structure on the basis of the closed-loop signal conditioning circuit, the magnetic field feedback coil, and the magnetic induction unit; the sensor performs conditioning and amplification, temperature compensation, and/or linearity correction on an electrical signal output by the magnetic signal output circuit on the basis of the closed-loop magnetic field feedback structure, and generates a feedback magnetic field to achieve dynamic magnetic field balance, thereby obtaining a second conditioned signal; and outputs the second conditioned signal; wherein the second conditioned signal represents a feedback current of the magnetic field feedback coil that achieves the state of dynamic magnetic field balance.

11. A multi-axis magnetic field sensor chip, **characterized in that** the chip is formed by packaging the multi-axis magnetic field sensor according to any one of claims 1-10 by means of wafer-level packaging (WLP) and through silicon via (TSV) processes.
